# EUROPÄISCHE PATENTSCHRIFT

(11) **EP 3 446 402 B1**
(45) Veröffentlichungstag und Bekanntmachung des Hinweises auf die Patenterteilung: **06.01.2021**
(21) Anmeldenummer: 17723021.6
(22) Anmeldetag: 21.04.2017
(51) Int. Cl.: H03K 17/96, G01L 1/14, H03K 17/975

(54) **ELASTOMERBASIERTES KAPAZITATIVES STEUER- UND BEDIENELEMENT**
ELASTOMER BASED CAPACITIVE CONTROL AND OPERATING ELEMENT
ÉLÉMENT DE PILOTAGE ET DE COMMANDE CAPACITIF À BASE D'ÉLASTOMÈRE

(30) Priorität: 22.04.2016 DE 102016107533
(43) Veröffentlichungstag der Anmeldung: 27.02.2019
(73) Patentinhaber: Fraunhofer-Gesellschaft zur Förderung der angewandten Forschung e.V., 80686 München (DE)
(72) Erfinder: BÖSE, Holger, 97080 Würzburg (DE); OCAK, Deniz, 97074 Würzburg (DE); KAPPENBERGER, Christopher, 91083 Baiersdorf (DE); EHRLICH, Johannes, 97355 Wiesenbronn (DE)
(74) Vertreter: Strehl Schübel-Hopf & Partner
(86) Internationale Anmeldenummer: PCT/EP2017/059548
(87) Internationale Veröffentlichungsnummer: WO 2017/182649

(56) Entgegenhaltungen:
- EP-A2- 2 698 616
- WO-A1-2016/003293
- US-B2- 7 863 822
- BÖSE HOLGER ET AL: "Applications of pressure-sensitive dielectric elastomer sensors", SPIE - INTERNATIONAL SOCIETY FOR OPTICAL ENGINEERING. PROCEEDINGS, S P I E - INTERNATIONAL SOCIETY FOR OPTICAL ENGINEERING, US, Bd. 9798, 15. April 2016 (2016-04-15), Seiten 97982C-97982C, XP060070762, ISSN: 0277-786X, DOI: 10.1117/12.2220808 ISBN: 978-1-5106-0753-8

## Beschreibung

Zum Bedienen von elektronischen Geräten sowie von Maschinen in vielen technischen Umgebungen wird eine Vielzahl von Bedienelementen benötigt. Dieser sogenannten Mensch-Maschine-Schnittstelle (HMI = Human Machine Interface) kommt wegen der steigenden Zahl von steuerbaren Funktionen eine wachsende Bedeutung zu. Das betrifft im Automobil beispielsweise die Bedienung einfacher Funktionen wie Beleuchtung, Hupe oder Fensterheber. Hinzu kommen aber immer mehr komplexe steuerbare Systeme wie Klimatisierung, Navigation und Entertainment.

Darüber hinaus sind Steuer- und Bedienelemente auch in vielen anderen technischen Systemen notwendig. Die Steuerung vieler Maschinen erfolgt über geeignete Benutzeroberflächen. Elektronische Geräte brauchen für die Benutzung auf ihre Funktionen abgestimmte Bedienelemente. Das betrifft nicht nur Computer, sondern auch Smartphones, Spielekonsolen und viele weitere Klassen von elektronischen Geräten. Eine noch am Anfang stehende Entwicklung ist die Integration von Elektronik in Kleidung. Wenn Bedienelemente auch in Textilien eingebunden werden sollen, müssen sie eine flache Form aufweisen und nach Möglichkeit weich und flexibel ausfallen, um einen hohen Tragekomfort zu bieten.

Bei der Gerätebedienung ist zwischen verschiedenen Arten der Beeinflussung zu unterscheiden. Das einfachste Bedienelement ist ein Schalter, der eine gewünschte Funktion wie z. B. Licht ein- und ausschaltet. Eine komplexere Bedienmöglichkeit verlangt die Steuerung oder Einstellung einer Stellgröße wie beispielsweise die Helligkeit oder die Lautstärke. Noch komplexer ist die Einstellung einer mehrdimensionalen Stellgröße. Ein Beispiel hierfür ist die Steuerung eines Spiegels, der in zwei Achsen verstellt werden kann.

Entsprechend dem hohen Bedarf steht bereits eine große Auswahl von Steuer- und Bedienelementen zur Verfügung. Zum einfachen Schalten werden überwiegend Druck-, Kipp-oder auch Drehschalter eingesetzt. Mit Drehschaltern lässt sich auch zwischen mehr als zwei Stufen hin- und herschalten. Zur Einstellung einer Stellgröße können Dreh- oder Schieberegler verwendet werden. Eine besonders durch die digitale Elektronik inzwischen häufig genutzte Bedienmethode besteht darin, die Stellgröße über ein mehrfach wiederholtes oder eine definierte Zeit anhaltendes Drücken eines Drucktasters einzustellen. Auf diese Weise werden z. B. die Elektromotoren zur Verstellung der Außenspiegel im Fahrzeug gesteuert. Für komplexere, z. B. zweidimensionale Einstellungen mit hoher Geschwindigkeit stehen beispielsweise Joysticks zur Verfügung. Auch die Computer-Maus erfüllt eine derartige Funktion. Dabei handelt es sich jedoch schon um relativ aufwendige Geräte mit hohem Platzbedarf. Auch Touch-Displays, die besonders in Smartphones weit verbreitet sind, ermöglichen eine zweidimensionale Steuerung. Wegen der damit verbundenen Berührung einer starren Glasplatte mit den Fingern ist damit jedoch keine Wahrnehmung von Druckkräften verbunden.

Bei den heute eingesetzten Steuer- und Bedienelementen handelt es sich in der Regel um starre Komponenten. Sie werden meist aus metallischen und nicht flexiblen Kunststoff-Bauteilen gefertigt. Demensprechend können sie in ihrer Form nachträglich nicht mehr verändert und angepasst werden. Für einen Einsatz in Textilien gibt es bislang keine geeigneten Bedienelemente.

Zum Stand der Technik werden die nachfolgenden Patentschriften angeführt, in denen Bedienelemente dargestellt sind, die mit einem kapazitiven Sensor ausgerüstet sind.

DE 10 2010 063 280 beschreibt ein Bedienelement mit kapazitivem Sensor. Die kapazitive Sensorik ist eine Näherungssensorik, die z. B. eine Funktionsanzeige oder eine Hinterleuchtung aktiviert. Eine Drucksensorik wird nicht erwähnt.

In EP 726 655 ist ein kapazitives Schaltelement dargestellt, bei dem ein Kondensator von oben zusammengedrückt und die dabei erzeugte Kapazitätsänderung gemessen wird. Die untere Elektrode besteht aus zwei Feldern, die mit Hilfe leitfähiger, metallischer Tinte aufgedruckt werden können. Das darüber liegende dielektrische Material besteht aus einer Mischung aus einem Ferroelektrikum und Glas. Als Schaltelement dient eine scheibenförmiges Element aus elektrisch leitendem, elastischem Material oder aus einem nichtleitenden elastischen Material, das in Richtung des Dielektrikums mit einer Metallfolie beklebt ist.

DE 10 2012 210 277 beschreibt einen kapazitiven Sensor zur Erfassung der Bewegung eines Objekts, beispielsweise einer (Druck- oder Kipp-)Taste. Eine der beiden Elektroden des Sensors ist starr mit der Taste verbunden oder mit dieser mechanisch gekoppelt, so dass sich die Elektrode bewegt, wenn die Taste bewegt wird. Bei dieser Bewegung ändert sich ihr Abstand zur feststehenden anderen Elektrode, wobei sich das Volumen zwischen den beiden Elektroden verändert, das teilweise aus einem verformbaren Dielektrikum in Form einer Linse und teilweise aus Gas besteht. Wird das Volumen verringert, wird Luft aus dem Gasvolumen herausgedrückt und durch Material des Dielektrikums ersetzt, wodurch die Kapazitätsänderung gesteigert wird.

In US 7,863,822 wird ein Bedienelement für ein Kraftfahrzeug beschrieben. Das Bedienelement enthält eine Schicht aus einem dielektrischen Elastomer, das in einem gewünschten Bereich mit einer Vorderelektrode ausgestattet ist, die dem Bediener zugewandt ist. Auf der dem Bediener abgewandten Seite befindet sich eine Rückelektrode. Durch Anlegen einer elektrischen Spannung zwischen den beiden Elektroden nimmt der Abstand zwischen der Vorderelektrode und der Rückelektrode ab, wodurch das dielektrische Elastomer im gewünschten Bereich zusammengedrückt wird. Wenn die Rückelektrode dabei ihre Stellung nicht verändert, entsteht eine dem Bediener zugewandte Vertiefung, die dieser als Veränderung der Oberfläche taktil wahrnehmen soll. Wenn beide Elektroden flexibel sind, entsteht eine Struktur, die beidseitig vertieft ist. In jedem Fall soll diese Struktur anschließend als Taster, Schlüssel oder Druckknopf genutzt werden. Das Drücken des Bedieners auf das Bedienelement kann außer durch einen zusätzlichen nicht näher spezifizierten Drucksensor auch über die Messung einer Kapazitätsänderung zwischen den beiden Elektroden registriert werden, wobei für diese Kapazitätsänderung nur eine Rest-Fähigkeit des Elastomers zur Verfügung steht, zusammengedrückt zu werden. Daher muss diese auch bei Wahl eines weichen Elastomers für die dielektrische Schicht relativ gering ausfallen.

In der Fachliteratur wird die kapazitive Sensierung der Verformung von dielektrischen Elastomeren in der Regel zur Überwachung aktorischer Anwendungen von dielektrischen Elastomeren (Marc Matysek et al.: Combined driving and sensing circuitry for dielectric elastomer actuators in mobile applications, Proc. SPIE 7976, Electroactive Polymer Actuators and Devices (EAPAD) 2011, 797612; doi:10.1117/12.879438) oder als reine Sensorfunktion (Holger Böse; Eric Fuß: Novel dielectric elastomer sensors for compression load detection, Proc. SPIE 9056, Electroactive Polymer Actuators and Devices (EAPAD) 2014, 905614; doi: 10.1117/12.2045133) genutzt.

DE 10 2013 004088 T5 offenbart eine elektrisch verstellbare Sitzvorrichtung, die Betätigungseinheiten aufweist, die als Kapazitätssensoren ausgebildet sind, welche aus zwei Elektroden und einer dazwischen befindlichen Elastomerschicht gebildet sind. Die Möglichkeit, eine gewünschte Stellgröße stufenlos einzustellen und mit Hilfe eines Auslösevorgangs festzustellen, ist nicht offenbart.

Hyung-Kew Lee et al., Journal of Microelectromechanical Systems Vol. 17, No. 4, 2008, S. 934-942, offenbaren einen flexiblen Berührungssensor, aufgebaut aus zwei Polydimethylsiloxanschichten mit eingebetteten Elektroden, sowie dazwischen einem Luftspalt und einer Säulenstruktur. Die Möglichkeit, eine gewünschte Stellgröße stufenlos einzustellen und mit Hilfe eines Auslösevorgangs festzustellen, ist nicht offenbart.

Aufgabe der Erfindung ist es, ein leicht und mit den Fingern bedienbares Steuerelement bereitzustellen, mit dem sich eine oder mehrere gewünschte Stellgrößen stufenlos einstellen und bei Bedarf mit Hilfe eines Auslösevorgangs feststellen lassen. Das Steuerelement soll bei Bedarf flexibel und biegbar, vorzugsweise sogar dehnbar sein.

Gelöst wird die Aufgabe durch die Bereitstellung eines Steuer- und Bedienelements, umfassend:
Steuer- und Bedienelement, umfassend:
(a) mindestens einen Dielektrischen Elastomersensor, bei dem mindestens zwei Elektrodenschichten, zwischen denen eine Kapazität gemessen werden kann, durch ein zumindest teilweise elastomeres Dielektrikum voneinander getrennt sind,
   wobei der Sensor eine voreingestellte Position besitzt und durch eine Verformung elastomerer Bestandteile eine oder mehrere Arbeitspositionen mit gegenüber der voreingestellten Position veränderter Kapazität einnehmen kann, die durch eine äußere Krafteinwirkung erreicht wird/werden, wobei die gemessene Kapazität dazu genutzt wird, um in dem Steuer- und Bedienelement eine Stellgröße zu steuern, und
(b) einen Auslösemechanismus, der ein Ereignis auslösen kann, das im Zusammenhang mit einer erreichten Arbeitsposition steht, wobei der Auslösevorgang beinhaltet, dass die zuvor mit Hilfe des Sensors erreichte(n) Arbeitsposition(en) und mit ihr/ihnen der dabei erhaltene Wert oder die erhaltenen Werte der Kapazität festgehalten und übernommen werden.

Der erfindungsgemäß genutzte Dielektrische Elastomersensor ist ein Sensor, der sich in der Regel flächig erstreckt. Unter dem Ausdruck "sich flächig erstreckend" soll erfindungsgemäß verstanden werden, dass der Sensor aus übereinander liegenden, vollständig oder teilweise aus Elastomermaterial bestehenden Komponenten (Schichten, die auch profiliert sein können) aufgebaut ist, wobei jede einzelne dieser Komponenten eine Flächenausdehnung besitzt, die in den Flächenrichtungen in der Regel mindestens so groß ist wie ihre Dicke, auch wenn dies nicht unbedingt zwingend ist. Häufig sind die Abmessungen des gesamten Aufbaus aller Komponenten (Schichten), also des Dielektrischen Elastomersensors, in der Länge und/oder in der Breite größer als die Dicke des Sensors (gemessen über seinen Querschnitt zwischen den nach außen weisenden Außenseiten der (ggf. äußersten) zwei elastomeren Elektrodenschichten), und nicht selten betragen sie ein Mehrfaches von dessen Dicke. Das Verhältnis der Länge und/oder der Breite zur Dicke beträgt häufig mindestens das Doppelte, in der Regel mindestens das Fünffache und meistens mindestens das Zehnfache. Häufig besitzen sowohl die Länge als auch die Breite diese Abmessungen in Relation zur Dicke. Als Querschnitt durch den Elastomersensor ist die kürzeste Strecke zwischen den Außenseiten der beiden äußeren bzw. äußersten Elektrodenschichten durch die Schichten hindurch anzusehen. Eine Krafteinwirkung in Richtung des Querschnitts wird erfindungsgemäß als "senkrecht zur Flächenrichtung" bezeichnet, eine "Krafteinwirkung mit zumindest einer Komponente in Flächenrichtung" ist eine Krafteinwirkung, bei der zumindest ein Teil der flächigen Komponenten des Sensors in Flächenrichtung gedehnt oder zusammengedrückt wird.

Die genannte äußere Krafteinwirkung besitzt vorzugsweise zumindest eine Komponente in Flächenrichtung des Dielektrischen Elastomersensors.

Selbstverständlich muss sich der sich flächig erstreckende Dielektrische Elastomersensor nicht zwingend ausschließlich in einer x-y-Ebene erstrecken, sondern kann ggf. statt dessen gebogen, geknickt oder gewellt sein oder eine andere Form besitzen oder annehmen, die eine Erstreckung in die z-Richtung des Raumes umfasst. Auch sollte klar sein, dass die einzelnen Komponenten des Sensors nicht immer parallel zueinander ausgerichtet sein müssen, auch wenn das in der Regel der Fall sein wird. In Ausnahmefällen sind jedoch auch keilförmige oder andere nicht-parallele Anordnungen möglich.

Das grundlegende Funktionsprinzip der erfindungsgemäßen Steuer- und Bedienelemente umfasst die Messung der Veränderung der elektrischen Kapazität von Dielektrischen Elastomersensoren bei deren Verformung, insbesondere mit den Fingern. Dielektrische Elastomersensoren (DES) existieren in verschiedenen Versionen und werden dazu genutzt, Dehnungen, Zug- oder Druckkräfte zu messen.

Die einfachste Version eines DES ist eine dielektrische Elastomerfolie. Diese umfasst eine stark dehnbare Elastomerfolie, die beidseitig mit ebenfalls stark dehnbaren Elektroden beschichtet ist. Die Elektroden behalten auch bei hoher Dehnung eine ausreichende elektrische Leitfähigkeit bei. Eine solche dielektrische Elastomerfolie hat damit die Form eines flächigen, häufig biegbaren Kondensators, dessen Kapazität von der Fläche der Elektroden und der Dicke der dazwischen liegenden Elastomerfolie abhängt. Wird die dielektrische Elastomerfolie gedehnt, so vergrößert sich die Fläche und verringert sich der Elektrodenabstand. Beides führt zu einer Erhöhung der Kapazität. Damit wirkt die dielektrische Elastomerfolie wie ein kapazitiver Dehnungssensor, mit dem auch Zugkräfte gemessen werden können. Solche dielektrischen Elastomerfolien und ihr Sensoreffekt sind bereits bekannt.

Aus den Patentanmeldungen EP 2 698 616 A2 und DE 10 2014 201 434 A1 sind Drucksensormatten bekannt, mit denen auch Druckbelastungen mit hoher Empfindlichkeit ebenfalls kapazitiv erfasst werden. Der Grundgedanke besteht darin, dass ein Schichtverbund aus einer planaren Elastomerfolie und ein oder zwei mit Oberflächenprofilen versehenen Elastomerfolien beim Zusammendrücken Verformungen erfährt, die zu einer deutlichen Erhöhung der gemessenen Kapazität führen. Dabei kommt der Position der leitfähigen Elektrodenschichten in dem Schichtverbund eine entscheidende Bedeutung zu. Für solche Drucksensoren bestehen vielfältige Designmöglichkeiten, mit denen sich die Empfindlichkeit in einem weiten Rahmen einstellen lässt. Eine besonders empfindliche Version lässt sich über einen Drucksensor mit einer Elastomerfolie zwischen zwei Noppenprofilen realisieren. Alle diese Ausgestaltungen sind erfindungsgemäß nutzbar, ohne dass die Erfindung darauf beschränkt wäre.

Die vorliegende Erfindung nutzt die vielfältigen Designmöglichkeiten von dielektrischen Elastomersensoren sowohl für Zug- als auch für Druckbelastungen. Dabei wird, vorzugsweise mit den Fingern einer Hand, eine Verformung des Steuer- und Bedienelements erzeugt, die zu einer messbaren Kapazitätsveränderung führt. Mit steigender Fingerkraft werden die Verformung und damit auch die Kapazitätsveränderung größer. Wird die Kraft zurückgenommen, so werden auch die Verformung und die Kapazitätsveränderung wieder kleiner. Die nachfolgend beschriebenen Ausführungsbeispiele stellen Steuer- und Bedienelemente mit dielektrischen Elastomersensoren sowohl für Zug- als auch für Druckbelastungen dar, die bei der Bedienung sehr hohe Änderungen der messbaren elektrischen Kapazität erzeugen und damit eine hohe Empfindlichkeit aufweisen.

Der Dielektrische Elastomersensor kann eine mit Elektroden beschichtete Elastomerfolie oder eine zwischen zwei Elastomerkomponenten mit nach innen gerichteten profilierten Oberflächen angeordnete Elastomerfolie aufweisen. In diesen Fällen kann die äußere Krafteinwirkung (Druckbelastung) zumindest teilweise senkrecht zur Oberfläche der Elastomerfolie aufgebracht werden, wobei sich im ersten Fall die Elektroden infolge eines mit einer seitlichen Dehnung verknüpften Zusammendrückens der Elastomerfolie einander nähern, so dass sich die Kapazität zwischen ihnen in der bzw. den Arbeitsposition(en) vergrößert. Da sich die Elektroden in der Regel mit der Elastomerfolie mitdehnen, wird zusätzlich die Fläche des Elastomersensors größer, was die Kapazität nochmals erhöht. Im Falle von Elastomerkomponenten mit nach innen gerichteten profilierten Oberflächen können diese so angeordnet sein, dass die Profile unter der Krafteinwirkung wechselseitig ineinander ein- oder aneinander angreifen, was wiederum eine Verringerung des Abstands der Elektroden zueinander bewirkt. In einer alternativen Variante befindet sich eine mit Elektrodenschichten versehene Elastomerfolie zwischen den Profilen. Diese wird beim Ineinandergreifen der Profile gedehnt, was zu einer Kapazitätsveränderung führt.

Der Dielektrische Elastomersensor kann mindestens eine Elastomerkomponente aufweisen, die mindestens auf einer ihrer Seiten eine profilierte Oberfläche besitzt. Die äußere Krafteinwirkung verändert in diesen Fällen die Form des Profils dieser Oberfläche.

Eine Komponente des Dielektrischen Elastomersensors kann ein Elastomerschaum sein, beispielsweise ausgestaltet als Dielektrikum zwischen zwei Elektrodenschichten. In diesem Fall kann die äußere Krafteinwirkung eine Stauchung des Elastomerschaums auslösen.

In manchen Fällen besitzt der dielektrische Elastomersensor dabei mehr als eine Dielektrikumsschicht und mehr als zwei Elektrodenschichten in einer alternierenden Schichtfolge.

Als Elastomermaterial für sowohl die leitfähigen als auch die nicht leitfähigen Elastomerkomponenten wird in den Steuer- und Bedienelementen vorzugsweise Silicon verwendet. Es können statt dessen aber auch andere Materialien eingesetzt werden, insbesondere Fluorsilicon, Polyurethan (PUR), Polynorbornen, Naturkautschuk (NR), Styrol-Butadien (SBR), Isobutylen-Isopren (IIR), Ethylen-Propylen-Dien-Terpolymer (EPDM/EPM), Poly-Chlorbutadien (CR), Chlorsulfoniertes Polyethylen (CSM), Acrylnitril-Butadien (NBR), Hydriertes Acrylnitril-Butadien (HNBR), einen Fluorkautschik wie Viton, ein thermoplastisches Elastomer wie thermoplastische Styrol-Copolymere (Styrol-Butadien-Styrol- (SBS-), Styrol-Ethylen-Butadien-Styrol- (SEBS-), Styrol-Ethylen-Propylen-Styrol- (SEPS-), Styrol-Ethylen-Ethylen-Propylen-Styrol- (SEEPS-) oder Styrol-Isopren-Styrol- (SIS-) Copolymer), teilvernetzte Blends auf Polyolefin-Basis (aus Ethylen-Propylen-Dien-Kautschuk und Polypropylen (EPDM/PP), aus Nitril-Butadien-Kautschuk und Polypropylen (NBR/PP) oder aus Ethylen-Propylen-Dien-Kautschuk und Polyethylen(EPDM/PE)) oder thermoplastische Urethan-Copolymere (aromatisches Hartsegment und Ester-Weichsegment (TPU-ARES), aromatisches Hartsegment und Ether-Weichsegment (TPU-ARET) oder aromatisches Hartsegment und Ester/Ether-Weichsegment (TPU-AREE)). Auch Mischungen von zwei oder mehr der genannten Materialien sind möglich. Doch können auch andere Elastomermaterialien verwendet werden, wie aus dem Stand der Technik bekannt.

Die nicht leitfähige Elastomerkomponente kann elektrisch polarisierbare Partikel wie Bariumtitanat, Bleizirkonattitanat oder Titandioxid und/oder elektrisch leitfähige Partikel aus Kohlenstoff wie, Ruß, Graphit, Graphen oder Carbon Nanotubes, Metalle wie Eisen, Kupfer, Silber oder Gold oder leitfähige Polymere wie Polyanilin, Polyacetylen, Polypyrrol, Polyparaphenylen oder Polythiophen oder eine organische Modifizierung zur Erhöhung der Permittivität enthalten. Selbstverständlich dürfen elektrisch leitfähige Partikel nur in einer solchen Menge eingesetzt werden, dass die Perkolationsschwelle nicht überschritten wird.

Die leitfähigen Elastomerkomponenten enthalten leitfähige Partikel aus Kohlenstoff wie Ruß, Graphit, Graphen oder Carbon Nanotubes, Metallen wie Eisen, Kupfer, Silber oder Gold oder leitfähigen Polymere wie Polyanilin, Polyacetylen, Polypyrrol, Polyparaphenylen oder Polythiophen. Doch können auch andere leitfähige Füllstoffe verwendet werden, wie aus dem Stand der Technik bekannt. Bevorzugt wird als elastomere Komponente für die leitfähigen Elastomerkomponenten Silicon verwendet.

Die Elektrodenschichten können in allen Ausgestaltungen der Erfindung zumindest teilweise aus elastomeren Komponenten bestehen. Dies ist jedoch nicht zwingend: Wenn die Elektrodenschichten aus auf der Oberfläche eines elastomeren Dielektrikums aufgebrachten elektrisch leitenden Teilchen bestehen, können sie sich ebenfalls der Dehnung anpassen, sofern genügend Teilchen in einem Verbund derart vorhanden sind, dass die Perkolationsschwelle während der Dehnung nicht unterschritten wird. Dies ist dem Fachmann bekannt.

Es sollte klar sein, dass erfindungsgemäß auch andere Ausgestaltungen des Dielektrischen Elastomersensors eingesetzt werden können, sofern dieser mindestens zwei Elektrodenschichten aufweist, zwischen denen eine Kapazität gemessen werden kann, und sofern diese Elektrodenschichten durch ein zumindest teilweise elastomeres Dielektrikum voneinander getrennt sind.

Die gemessene Kapazität wird dazu genutzt, um in dem Steuer- und Bedienelement eine Stellgröße zu steuern. Dies erfolgt über die Ruheposition, die mit einem Anfangswert der Stellgröße, z.B. "aus" oder "minimal" gekoppelt ist, sowie einer oder mehreren Arbeitspositionen, in der bzw. denen die Kapazität des Dielektrischen Sensors durch die die Verformung durch die äußere Krafteinwirkung verändert ist. Der Übergang verschiedener Arbeitspositionen kann dabei fließend sein. Bei komplexeren Steuervorgängen, etwa bei mehrdimensionalen Stellgrößen, können auch mehrere Kapazitäten gleichzeitig verändert, gemessen und ausgewertet werden.

Während oder nach der Einstellung des gewünschten Wertes der jeweiligen Stellgröße kann dieser erfindungsgemäß auch übernommen werden. Hierzu ist ein Auslösevorgang in dem Steuer- und Bedienelement notwendig. Für den Auslösevorgang werden mehrere Optionen vorgeschlagen; diese sind vorzugsweise jeweils mit einer Verformung eines elastomeren Elements des Steuer- und Bedienelements verknüpft:
- Schließen oder - vice versa - Öffnen eines elektrischen Kontaktes, beispielsweise durch eine bestimmte Verformung von Elastomerkomponenten in dem Steuer- und Bedienelement. Hierbei kann ein Stromkreis vorgesehen sein, der in der voreingestellten Position des Steuer- und Bedienelements unterbrochen oder, vice versa, geschlossen ist und in einer zweiten oder weiteren Arbeitsposition, die als Auslöseposition des Steuer- und Bedienelements fungiert, geschlossen oder, vice versa, geöffnet wird, wobei das Öffnen bzw. Schließen des Kontakts den Vorgang auslöst. Alternativ kann das Ankontaktieren einer elektrischen leitenden Struktur am Dielektrischen Elastomersensor mittels einer weiteren elektrischen Struktur ein Signal und damit den Vorgang auslösen. Eine bevorzugte Ausführungsform besteht darin, dass die elektrisch leitfähigen Komponenten, zwischen denen der Kontakt geschlossen oder geöffnet wird, auch aus Elastomer bestehen.
- Erfassung einer definierten zeitlichen Änderung der gemessenen Kapazität oder einer Kombination von Kapazitäten in dem Steuer- und Bedienelement. Hierfür kann ein Schwellwert für die Geschwindigkeit der Änderung der gemessenen Kapazität voreingestellt sein, dessen Überschreitung das Ereignis auslöst.
- Erfassung einer definierten Änderung einer Kombination von mehreren Kapazitäten in dem Steuer- und Bedienelement. Dabei kann es sich, muss aber nicht, um die Voreinstellung von zwei Kapazitätsänderungen in vorzugsweise zwei Dielektrischen Elastomersensoren oder in zwei Feldern eines elektrischen Dielektrischen Elastomersensors handeln. Wird die Kombination dieser Kapazitätsänderungen erreicht, wird das Ereignis ausgelöst.
- Erfassung der Änderung einer anderen Kapazität oder einer Kombination von Kapazitäten in dem Steuer- und Bedienelement. Hierfür kann z.B. ein zusätzlicher Dielektrischer Elastomersensor vorgesehen sein, bei dem mindestens zwei Elektrodenschichten, zwischen denen eine Kapazität gemessen werden kann, durch ein zumindest teilweise elastomeres Dielektrikum voneinander getrennt sind. Ein solcher Sensor kann beispielsweise in einer an dem Steuer- und Bedienelement vorhandenen Greifeinrichtung angeordnet sein. Eine Kapazitätsänderung dieses zusätzlichen Dielektrischen Elastomersensors kann das Ereignis auslösen.

Der Auslösevorgang ist in dem erfindungsgemäßen Steuer- und Bedienelement von wesentlicher Bedeutung, weil damit die zuvor mit Hilfe der Deformation des Sensors erreichte(n) Arbeitsposition(en) und mit ihr/ihnen der dabei erhaltene Wert oder die erhaltenen Werte der Kapazität festgehalten und übernommen werden können ("Auslösen eines Ereignisses").

In speziellen Ausgestaltungen kann der Auslösemechanismus des Steuer- und Bedienelements mit einem Schnappmechanismus verbunden werden. Beim Schnappmechanismus handelt es sich um ein mechanisch bistabiles Element mit einer Rückstellfeder. Bei der Kraftausübung auf den Sensor wird zunächst eine ansteigende Kraft auf eine Oberfläche des mechanisch bistabilen Elements ausgeübt, die eine elastische Gegenkraft erzeugt, welche zuerst ansteigt und beim Überschreiten eines Druckpunktes schlagartig abnimmt. Durch dieses Schnappen erfährt der Benutzer eine haptische Rückmeldung an seiner Hand. Mit der Schnappbewegung wird gleichzeitig ein Auslösemechanismus betätigt, wie z. B. das Schließen oder Öffnen eines elektrischen Kontaktes. Bei einer nachfolgenden Reduzierung der ausgeübten Kraft wird die Oberfläche des Elements durch die Feder in ihre Ausgangsposition zurückbewegt. Die Komponenten des Schnappmechanismus' können aus Elastomer und/oder Metall gefertigt sein.

Das eigentliche Auslösen erfolgt auch bei diesen Ausgestaltungen der Erfindung wie oben angegeben:
1. Schließen oder Öffnen eines elektrischen Kontaktes (auch über leitfähige Elastomerkomponenten)
2. Registrierung einer schnellen Kapazitätsänderung
3. Starten des Auslösevorgangs bei Erreichen einer vorgegebenen Kombination von mindestens 2 Kapazitätsänderungen.
4. Registrierung der Änderung einer zusätzlichen Kapazität

Die Erfindung stellt damit eine neue Klasse von Steuer- und Bedienelementen bereit, die überwiegend oder vollständig aus elastomeren Komponenten aufgebaut sind. Damit wird es möglich, die Steuer- und Bedienelemente flexibel, d. h. biegbar, und bei Bedarf sogar dehnbar auszulegen. Dies geschieht einerseits durch den geometrischen Aufbau des Steuer- und Bedienelements und andererseits durch die Auswahl der verwendeten Elastomermaterialien.

Durch die elementaren Grundfunktionen der neuen Steuer- bzw. Steuer- und Bedienelemente kann durch die Anwendung einer definierten Kraft, insbesondere mit den Fingern einer Hand, der Sensor in eine Arbeitsposition gebracht werden, wobei in dieser Position eine Stellgröße einen gewünschten Wert besitzt, und wobei bei Bedarf sofort anschließend ein Auslösevorgang mit denselben Fingern durchgeführt werden kann, mit dem der gewünschte Wert der Stellgröße übernommen wird. Bereits mit verhältnismäßig geringem Aufwand lassen sich auch Steuer- und Bedienelemente realisieren, die zweidimensionale, dreidimensionale oder sogar mehrdimensionale Einstellungen von Stellgrößen zulassen. Die Designvielfalt dieser Elemente ist sehr hoch. Außer über den geometrischen Aufbau lässt sich auch über die Auswahl der verwendeten Elastomermaterialien, insbesondere über den Grad der chemischen Vernetzung, die Empfindlichkeit einstellen, mit der das Steuer- und Bedienelement auf den ausgeübten Fingerdruck reagiert.

Die erfindungsgemäßen Steuer- bzw. Steuer- und Bedienelemente zeichnen sich dadurch aus, dass sie relativ einfach aufgebaut sind, keine teuren Materialien benötigen und kostengünstig produziert werden können. Damit eignen sie sich auch für den Einsatz in vielen Massenmärkten.

Die mit den Fingern erzeugte Kapazitätsveränderung bzw. die verschiedenen Kapazitätsveränderungen werden mit Hilfe eines Prozessors in den Wert einer Stellgröße oder einen Satz von Stellparametern umgerechnet, um ein technisches System einzustellen. Beispiele sind die Lautstärke eines Schallerzeugers, die Helligkeit einer Lampe, die Strahlungsrichtung einer Lampe oder die Ausrichtung eines Spiegels oder von anderen optischen Komponenten. Die bedienende Person erfährt ohne störende Verzögerung die Wirkung ihrer gegenwärtigen Einstellung und kann diese bei Bedarf verändern. Mit dem Auslösevorgang fixiert sie dann die gewünschte Einstellung.

Die möglichen Kapazitäten zwischen den Elektroden können dabei in einer Auswerteschaltung mit Werten für eine oder mehrere technische Funktionen oder Parameter verknüpft sein. Im Ruhezustand des Elements besitzt oder besitzen diese Funktionen einen vorgegebenen Wert, beispielsweise "Licht aus" oder "Licht mit x Lux". Wird in der genannten ersten Ausgestaltung der Erfindung der Sensor in eine Arbeitsposition gebracht, in der die Kapazität zwischen den Elektroden verändert ist, so verändert sich dieser Wert/verändern sich diese Werte, z.B. "Licht mit y Lux" (z.B. helleres Licht) oder dergleichen. Ein erfindungsgemäßes Element gemäß dieser Ausgestaltung dient also der Steuerung eines oder mehrerer solcher Funktionen oder Parameter.

Nachfolgend wird die Erfindung unter Bezugnahme auf weitere Einzelheiten und spezielle Ausführungsformen näher erläutert.

In einer ersten Ausgestaltung der Erfindung wird durch die genannte äußere Krafteinwirkung die Kapazität zwischen den Elektroden verändert. Des Weiteren wird mit Hilfe der Krafteinwirkung der Sensor räumlich verändert und verformt, wodurch das genannte Ereignis ausgelöst wird. Dies gelingt z.B. durch das Vorsehen einer Kontaktstruktur am Steuer- und Bedienelement, die bei der räumlichen Veränderung und Verformung mit einer am Sensor angebrachten elektrisch leitenden Struktur in Kontakt kommt, wodurch das Ereignis ausgelöst wird. Durch die Zusammenführung der am Sensor befindlichen Struktur mit der Kontaktstruktur wird z.B. ein Stromkreis geschlossen, der im Ruhezustand des Elements unterbrochen ist, oder es wird über den Kontakt zwischen der am Sensor angebrachten elektrisch leitenden Struktur mit der Kontaktstruktur ein Signal ausgelöst. In beiden Fällen wird dabei ein Ereignis ausgelöst, nämlich eine Übernahme der augenblicklichen Kapazität(en) und damit der mit dieser/diesen Kapazität(en) in der Auswerteschaltung verknüpften technischen Funktion oder des damit verknüpften Parameters bewirkt.

Die am Sensor angebrachte elektrisch leitende Struktur kann eine separate Struktur sein, die beispielsweise seitlich an dem Dielektrischen Elastomersensor angebracht ist. In dieser Variante befindet sich die Kontaktstruktur am Steuer- und Bedienelement seitlich beabstandet hierzu. Diese kann beispielsweise in einen Rahmen integriert sein. Wird der Elastomersensor vertikal zusammengedrückt, beispielsweise durch Fingerdruck dieser Person, nimmt der Sensor in dieser Variante in einem ersten Stadium des Zusammendrückens eine Arbeitsposition ein, in der die Kapazität des Sensors verändert ist, wobei die damit verknüpfte Funktion bzw. der entsprechende Parameter verändert wird, was von dieser Person beobachtet werden kann. Ist der gewünschte Wert erreicht, wird der Elastomersensor zur Seite gedrückt bzw. geschert, bis die am Sensor angebrachte elektrisch leitende Struktur die Kontaktstruktur erreicht hat und den Kontakt schließt. Dabei wird ein Ereignis ausgelöst, nämlich dieser Wert übernommen, also eingestellt. Er wird dann auch beibehalten, wenn die Krafteinwirkung auf den Sensor endet.

Die am Sensor angebrachte elektrisch leitende Struktur kann aber auch mit einer Fläche einer der Elektrodenschichten identisch sein. In diesem Fall wird die Kontaktstruktur unterhalb des Dielektrischen Elastomersensors angebracht, bezogen auf die Fläche, die einer bedienenden Person zugewandt ist. Der Sensor wird hier seitlich verformt, bis der gewünschte Wert der Kapazität eingestellt ist. Anschließend wird der Sensor in dieser Arbeitsposition nach unten gedrückt, um den Kontakt auszulösen.

Das Schließen des Stromkreises ist genauso reversibel wie das Herstellen des Kontaktes zwischen einer am Sensor befindlichen Struktur und einer Kontaktstruktur. Da die Sensor-Strukturen elastomer sind, wird bei nachlassender Krafteinwirkung der Kontakt wieder gelöst. Wird die Kraft erneut aufgebracht, z.B. zum Erzielen einer anderen Arbeitsposition, wird der Kontakt erneut geschlossen.

Auch in einer zweiten Ausgestaltung der Erfindung wird durch die genannte äußere Krafteinwirkung die Kapazität zwischen den Elektroden verändert. Doch wird hierbei das auslösende Ereignis ausschließlich mit Hilfe dieser Krafteinwirkung ausgelöst: In dieser Ausgestaltung lässt sich die Geschwindigkeit der Kapazitätsänderung messen. Durch die Erfassung einer definierten zeitlichen Änderung der gemessenen Kapazität wird das Ereignis ausgelöst, beispielsweise dadurch, dass ein Schwellwert für die Geschwindigkeit der Kapazitätsänderung überschritten wird. Eine langsame Krafteinwirkung kann so dazu dienen, dass eine bedienende Person in die Lage versetzt wird, eine Äquivalenz zwischen dieser Krafteinwirkung und der technischen Funktion oder dem Parameter zu beobachten, die/der eingestellt werden soll. Ist der gewünschte Wert erreicht, wird die Krafteinwirkung schnell über den Schwellwert hinaus erhöht, was zur Auslösung, d.h. der Feststellung des gerade herrschenden Wertes oder erreichten Parameters führt. In dieser Ausgestaltung der Erfindung kann die Krafteinwirkung vertikal erfolgen; sie kann aber auch horizontal erfolgen. Für diese letztere Variante kann der Dielektrische Elastomersensor, der hier vorzugsweise als Folie mit auf den Oberflächen der Folie aufgebrachten Elektrodenschichten realisiert ist, in einem Rahmen vorgespannt vorliegen. Wird die mechanische Spannung durch eine zumindest teilweise horizontale Krafteinwirkung (Krafteinwirkung in der Ebene der Folie) erhöht oder verringert, ändert sich die Kapazität des Sensors.

In einer dritten Ausgestaltung der Erfindung erfolgt das Auslösen über eine definierte Änderung einer Kombination von mehreren Kapazitäten in dem Steuer- und Bedienelement.

In einer vierten Ausgestaltung der Erfindung erfolgt das Auslösen über einen zusätzlichen Dielektrischen Elastomersensor. Dieser kann beispielsweise in einer Greifeinrichtung vorhanden sein, die dazu dient, die Kapazität des ansonsten einzigen oder eines der ansonsten vorhandenen Dielektrischen Elastomersensoren zu verändern.

In spezifischen Ausführungsformen der Erfindung besitzt das Steuer- und Bedienelement einen Dielektrischen Elastomersensor, der in zwei oder mehr Sensorflächen unterteilt ist. Hierbei sind die Elektrodenflächen strukturiert auf eine dielektrische Elastomerfolie oder andere dielektrische Komponenten des Elastomersensors aufgebracht, derart, dass voneinander elektrisch isolierte Elektrodenfelder gebildet werden. Die Sensorflächen können über die jeweiligen Elektrodenfelder elektrisch separat ausgelesen werden. Bevorzugt ist der Dielektrische Elastomersensor in diesen Ausführungsformen vorgespannt, beispielsweise durch Einspannen in einen Rahmen. Wird die dielektrische Elastomerfolie oder die entsprechende andere dielektrische Komponente seitlich verschoben, so wird eine von zwei Sensorflächen oder ein Teil der mehreren Sensorflächen mechanisch entspannt, wobei sich der Abstand der Elektroden erhöht und die Sensorfläche(n) verkleinert/verkleinern, was die Kapazität dieser Sensorflächen verringert. Die andere Sensorfläche bzw. der andere Teil der mehreren Sensorflächen wird dagegen noch stärker gespannt, wodurch sich der Abstand der Elektroden verringert und die Sensorfläche(n) vergrößert/vergrößern, was die Kapazität dieser Sensorflächen erhöht.

Das Verschieben der Elastomerfolie kann beispielsweise mit Hilfe einer Greifeinrichtung wie z.B. einem Knopf erfolgen, die beispielsweise auf einem Teil der Elastomerfolie angeordnet ist, die nicht mit Elektroden bedeckt ist. Die Greifeinrichtung befindet sich vorzugsweise mittig auf der Folie.

Die Auslösung kann bei Steuer- und Bedienelementen der Erfindung mit in zwei oder mehr Sensorflächen unterteilten Dielektrischen Elastomersensoren beispielsweise über eine unterhalb der Sensorfläche befindliche Kontaktstruktur wie für die erste Ausgestaltung der Erfindung beschrieben oder über eine Erfassung einer definierten zeitlichen Änderung der gemessenen Kapazität oder in einer gleichzeitigen Änderung mehrerer Kapazitäten wie für die zweite und dritte Ausgestaltung der Erfindung beschrieben erfolgen. Und schließlich ist es im Falle des Vorhandenseins einer Greifeinrichtung möglich, in dieser einen weiteren Dielektrischen Elastomersensor unterzubringen, derart, dass ein Zusammendrücken der Greifeinrichtung zu einer Kapazitätsänderung des weiteren Dielektrischen Elastomersensors führt, wodurch das Ereignis ausgelöst wird. Vorzugsweise bestehen auch die Komponenten für den Auslösemechanismus zumindest teilweise aus Elastomer.

Beim Vorhandensein von zwei oder mehr Sensorflächen kann die Relation der Flächengröße/Kapazität der Flächen zueinander erfasst werden. Im Falle von vier Flächen können die Sensorfelder z.B. quadratisch oder rechteckig oder rund angeordnet werden, derart, dass sich zwei isolierende, die Sensorfelder trennende Bereiche mittig schneiden. An der Schnittstelle kann eine Greifeinrichtung, z.B. ein Knopf angeordnet sein. In dieser Ausgestaltung kann die Bewegung des Knopfs über die Kapazitätsänderungen der Sensorfelder zweidimensional wie ein Cursor auf einer Fläche gesteuert und detektiert werden. Damit kann das erfindungsgemäße Steuer- und Bedienelement auch wie eine Computermaus genutzt werden, wobei die Größe dieses Elements deutlich kleiner gehalten werden kann als die einer solchen Maus, z.B. mit einer Grundfläche von 5-10 cm².

In einer speziellen Variante der Erfindung besitzt das Steuer- und Bedienelement mehrere Dielektrische Elastomersensoren, die, ggf. mit der Ausnahme eines solchen Sensors als Mittel zum Auslösen des genannten Ereignisses, mit jeweils unterschiedlichen Funktionen oder Parametern verknüpft sind. Diese Dielektrischen Elastomersensoren können als Wände eines gedachten oder tatsächlich vorhandenen dreidimensionalen Raums, beispielsweise eines Würfels, ausgebildet sein, wobei die Krafteinwirkung auf ihre jeweiligen Innenseiten erfolgen soll. Damit dies möglich ist, wird ein dreidimensionaler Körper im Inneren des Raums vorgesehen, der über eine aus dem Raum nach außen geführte Stange bewegt wird und dabei so eine äußere Kraft auf einen oder mehrere der Dielektrischen Elastomersensoren ausüben kann. Die Greifeinrichtung kann mit einem weiteren Dielektrischen Elastomersensor zum Auslösen des Ereignisses versehen sein, wie oben im Zusammenhang mit den in mindestens zwei Sensorflächen unterteilten Dielektrischen Elastomersensoren beschrieben.

In bevorzugten Ausführungsformen der Erfindung besitzt das erfindungsgemäße Steuer- und Bedienelement eine elektrisch isolierende Schicht, die sich auf der einer bedienenden Person zugewandten Oberfläche des sich flächig erstreckenden Dielektrischen Elastomersensors befindet. Diese Schicht, die auch als Deckschicht dienen kann, steht derart in mechanischem Kontakt mit dem Dielektrischen Elastomersensor, dass über ihre Oberfläche die äußere Krafteinwirkung auf den Dielektrischen Elastomersensor ausgeübt werden kann. Diese Deckschicht kann sich entweder über die gesamte Fläche des Dielektrischen Elastomersensors erstrecken; sie kann dann, wenn die Elektrodenschichten in strukturierter Form vorhanden sind, alternativ auch nur auf den elektrisch leitenden Strukturen vorhanden sein. Auch die vom Benutzer abgewandte Elektrodenschicht kann in manchen Ausgestaltungen mit einer nicht leitfähigen Deckschicht versehen sein, wenn sie nicht zur Ankontaktierung benötigt wird.

In allen Ausführungsformen der Erfindung ist es günstig, wenn die Verformung der Elastomerkomponenten so groß ist, dass sich der Abstand zwischen zwei ausgewählten Positionen im Elastomer um mindesten 10%, bevorzugt um mindestens 30% und besonders bevorzugt um mindestens 50% verändern kann. Dies gelingt durch Einsatz beispielsweise der Dielektrischen Elastomersensoren, wie sie in EP 2 698 616 A2 und DE 10 2014 201 434 A1 gezeigt sind.

In ebenfalls speziellen Ausgestaltungen, die mit allen anderen Ausgestaltungen der Erfindung kombinierbar sind, ist das Material, aus dem das erfindungsgemäße Steuer- und Bedienelement gefertigt ist, zumindest teilweise lichtdurchlässig, so dass Licht von der (dem Benutzer abgewandten) Rückseite oder einer anderen Seite durch das Steuer- und Bedienelement hindurch auf die dem Benutzer zugewandte Seite hindurchdringen kann. Das Licht einer Hinterleuchtung kann beispielsweise durch eine Unterbrechung in den Elektroden an die Vorderseite des Steuer- und Bedienelements gelangen.

In vielen Ausgestaltungen der Erfindung wird ein Dielektrischer Elastomersensor verwendet, der in mechanisch vorgedehnter Form eingesetzt wird. Um die Vordehnung zu stabilisieren, kann in diesen Fällen der Elastomersensor in einen Rahmen eingespannt sein.

Der Elastomersensor kann auch mit einer Platte oder mit einem anderen mechanischen Zwischenteil bedeckt werden, sodass der berührende Finger mit der Platte oder dem Zwischenteil und nicht direkt mit dem Sensor in Kontakt kommt. Damit wird ein verändertes haptisches Verhalten bei der Berührung erzeugt.

Das Steuer-und Bedienelement kann auch mit einer kapazitativen Näherungssensorik ausgestattet werden, wobei zusätzliche Elektrodenschichten an der Oberfläche des Steuer- und Bedienelements die Näherung einer Hand registrieren, indem das in den Raum hineinreichende elektrische Feld durch die Hand verändert wird, wodurch sich die an den zusätzlichen Elektrodenschichten gemessene Kapazität verändert.

Mit dem elastomerbasierten kapazitiven Steuer- und Bedienelement können Stellgrößen von technischen Funktionen durch eine gezielte Krafteinwirkung mit den Fingern eingestellt und fixiert werden. Es handelt sich dabei um eine neue Klasse von Mensch-Maschine-Schnittstellen. Durch die große Designvielfalt kann das Steuer- und Bedienelement an die Anforderungen in vielen Anwendungsbereichen angepasst werden.

Besondere Vorteile liegen im einfachen Aufbau, im Einsatz kostengünstiger Materialien und in den daraus resultierenden niedrigen Herstellungskosten. Damit ist diese Technologie auch für Massenmärkte geeignet. Im Gegensatz zu den meisten heute verfügbaren Bedienelementen können die neuen Steuer- und Bedienelemente durch die Verwendung elastomerer Komponenten flexibel und bei Bedarf auch dehnbar ausgelegt werden. Darüber hinaus lassen sich mit dem Ansatz auch Bedienelemente zur Steuerung mehrdimensionaler Stellgrößen realisieren.
- Steuerung von vielfältigen technischen Funktionen im Automobil wie z. B. Beleuchtung, Spiegeleinstellung, Klimatisierung, Navigation, Entertainment u.a.
- Mensch-Maschine-Schnittstellen zur Steuerung von Maschinen, ggf. auch für komplexe Abläufe, Ersatz von Joysticks
- Bedienelemente zur Steuerung von elektrischen Haushaltsgeräten wie Waschmaschinen, Küchengeräte, Staubsauger, Rasenmäher, etc.
- Nutzung in elektronischen Geräten wie Fernsehern, Musikanlagen, Computern, etc.
- Einsatz in mobilen Geräten wie Laptops, Notebooks, Smartphones, Kameras, etc.
- Integration in Textilien, Kleidungsstücke sowie auch andere flexible Umgebungen wie Sitzpolster, Betten, Schaumstoff-Verkleidungen, etc.

Das erfindungsgemäße Steuer- und Bedienelement kann also u.a. zur Steuerung von technischen Funktionen in Fahrzeugen, von Maschinen und von medizinischen Geräten sowie zur Bedienung von elektronischen Geräten wie Computern, Tablets, Smartphones und Spielekonsolen eingesetzt werden. Außerdem eignet es sich zur Steuerung von technischen Funktionen am Körper, auch mit Integration in Textilien und Kleidungsstücke, sowie in anderen flexiblen Umgebungen wie Sitze, Betten, Schaumstoff-Verkleidungen, etc.

Die neue Klasse von Steuer- und Bedienelementen kann in einer sehr großen Zahl von Anwendungen in verschiedenen Umgebungen genutzt werden:
- In Fahrzeugen können mit den Steuer- und Bedienelementen viele Einstellungen vorgenommen werden. Beispiele sind die Stärke und Richtung von Beleuchtungen, die Lautstärke der Sound-Anlage, Spiegelverstellungen, die Klimaanlage und das Navigationssystem. Besondere Möglichkeiten ergeben sich auch dadurch, dass die neuen Steuer- und Bedienelemente weich und flexibel sind. Damit lassen sie sich auch an ungewöhnlichen Stellen wie am Lenkrad, an der Innenverkleidung oder an Sitzen integrieren.
- Bei der Bedienung von Maschinen können die neuen Steuer- und Bedienelemente ebenfalls an verschiedenen Stellen genutzt werden, um beispielsweise Bewegungen zu steuern. Dies betrifft auch künftige Generationen von Robotern.
- Ein weiteres Einsatzfeld mit hohen Stückzahlen sind Haushaltsgeräte, beginnend von Waschmaschinen über große und kleine Küchengeräte bis hin zu Rasenmähern. Auch Bedienfunktionen in Sesseln, Betten oder Möbeln sind denkbar.
- Ein bis heute noch weitgehend unerschlossenes Einsatzgebiet für Bedienelemente sind Textilien und Bekleidung. Mit dem Fortschreiten der Verbreitung mobiler elektronischer Hilfsmittel steigt auch der Bedarf nach Bedienmöglichkeiten direkt an der Kleidung. Hierfür weisen die neuen flexiblen Steuer- und Bedienelemente wesentliche Vorteile auf.

### Ausführungsbeispiele:

### Ausführungsbeispiel 1

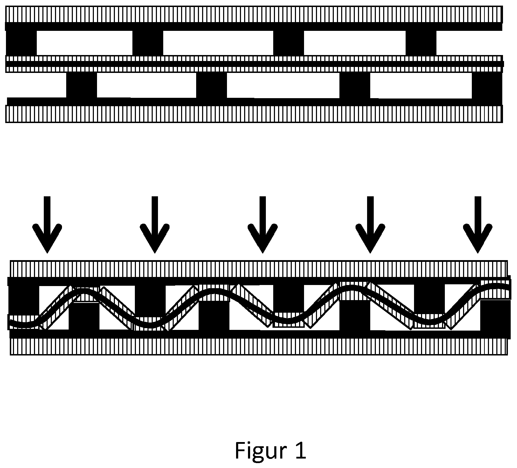

In **Figur 1** wird in Seitenansicht ein Drucksensor gezeigt, der aus zwei Elastomerfolien mit Noppenprofilen und Elektrodenbeschichtungen aus leitfähigem Elastomer innen besteht. Zwischen den Noppen liegt eine Elastomerfolie mit leitfähiger Innenschicht und nicht leitfähigen Außenschichten. Die leitfähige Innenschicht dient als Gegenelektrode zu den äußeren Elektrodenschichten; Die linke Figur zeigt den Sensor im Zustand ohne Druckbeaufschlagung. In der rechten Figur ist der Sensor im komprimierten Zustand dargestellt. Beim Zusammendrücken nähern sich die Elektrodenschichten aneinander an, wodurch die Kapazität ansteigt. Solche Drucksensoren sind aus EP 13 180 789.3 bereits bekannt.

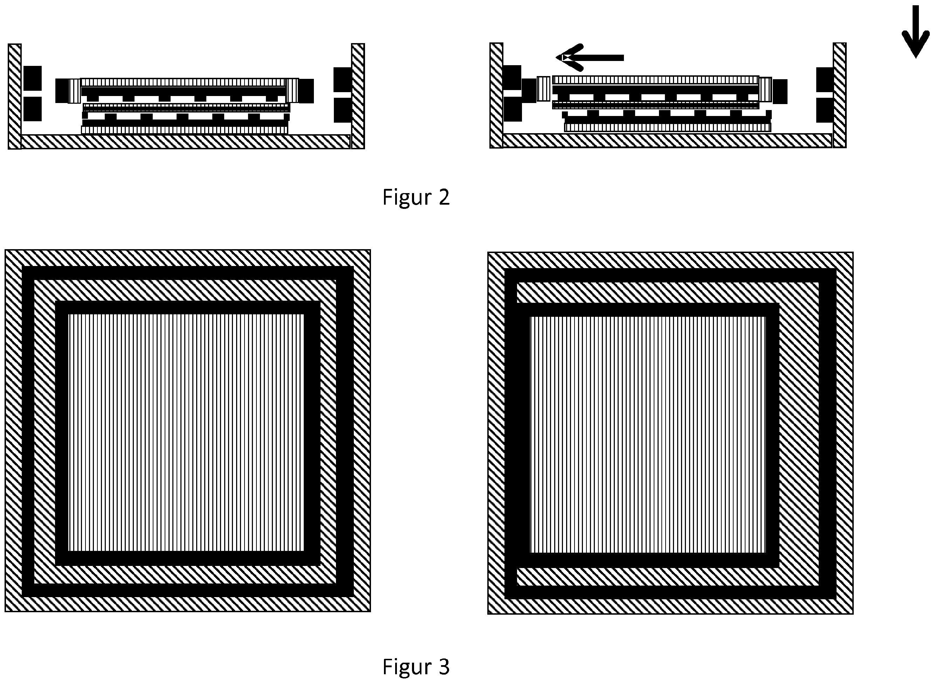

**Figur 2** zeigt in Seitenansicht ein Steuer- und Bedienelement aus einem Drucksensor, wie er in Figur 1 gezeigt ist, mit einem zusätzlichen Kontaktstreifen aus leitfähigem Elastomer an der oberen Elastomerfolie mit Noppenprofil. Ein weiterer Kontaktstreifen aus leitfähigem Elastomer mit Unterbrechung ist an einem Außenteil des Steuer- und Bedienelements angebracht. Dieser ist Bestandteil eines - hier erst einmal unterbrochenen - Stromkreises. Wird die Unterbrechung überbrückt, wird ein damit verbundener Stromkreis geschlossen. In dieser Ausgestaltung ist der Sensor fest an einer Unterlage befestigt. Bei einer Scherbelastung in der Mitte des Steuer- und Bedienelements wird die Oberseite seitlich verschoben, was einen elektrischen Kontakt auslöst. Die linke Figur zeigt das Steuer- und Bedienelement im nicht auslösenden Zustand, die rechte Figur zeigt es im auslösenden Zustand durch Scherung.

**Figur 3** zeigt dasselbe Steuer- und Bedienelement in der Ansicht von oben. Die linke Figur zeigt das Steuer- und Bedienelement im nicht auslösenden Zustand, die rechte Figur zeigt es im auslösenden Zustand durch Scherung.

### Ausführungsbeispiel 2

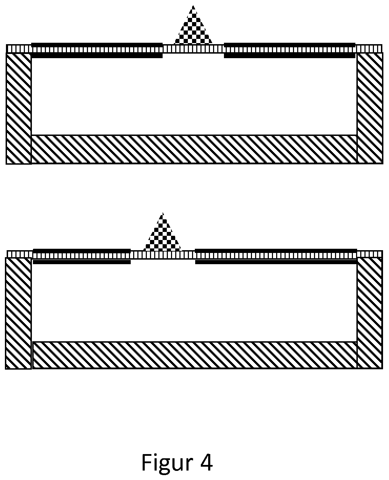

**Figur 4** zeigt in Seitenansicht ein Steuer- und Bedienelement mit einem Foliensensor mit zwei separaten Elektrodenfeldern und einem Fingerknauf oben in der Mitte. Die Elektroden der beiden Elektrodenfelder sind oben und unten auf der nicht leitfähigen Elastomerfolie aufgebracht. Eine dielektrische Elastomerfolie mit zwei separaten Elektrodenfeldern ist für aktorische Anwendungen bereits bekannt. Die linke Figur zeigt das Steuer- und Bedienelement im nicht betätigten Zustand, die rechte Figur zeigt es im nach links verschobenen Zustand. Durch die Verschiebung des Fingerknaufes nach links wird die Kapazität des linken Elektrodenfeldes verkleinert und die Kapazität des rechten Elektrodenfeldes vergrößert. Das Auslösen kann durch eine schnelle Bewegung nach links oder rechts erfolgen. Alternativ ist auch ein Hinunterdrücken des Fingerknaufes möglich, wodurch sich beide Kapazitäten erhöhen.

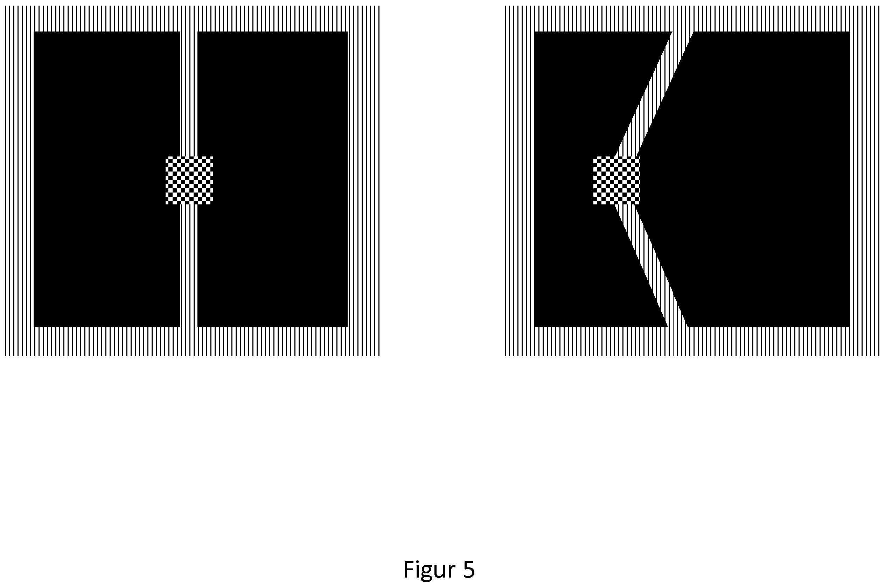

**Figur 5** zeigt in der Ansicht von oben das Steuer- und Bedienelement mit Foliensensor aus Figur 4 mit zwei separaten rechteckigen Elektrodenfeldern und Fingerknauf in der Mitte. Die linke Figur zeigt das Steuer- und Bedienelement im nicht betätigten Zustand, die rechte Figur zeigt es im nach links verschobenen Zustand.

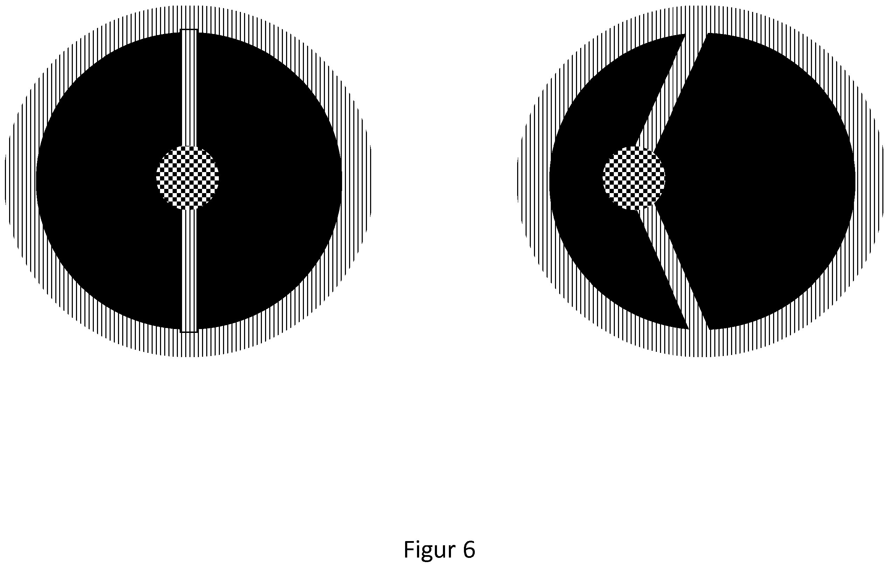

**Figur 6** zeigt in der Ansicht von oben das Steuer- und Bedienelement mit Foliensensor aus Figur 4 mit zwei separaten Kreissegment-Elektrodenfeldern und Fingerknauf in der Mitte. Die linke Figur zeigt das Steuer- und Bedienelement im nicht betätigten Zustand, die rechte Figur zeigt es im nach links verschobenen Zustand.

Ein Auslösemechanismus kann in diesem Beispiel z.B. im Fingerknauf untergebracht sein.

### Ausführungsbeispiel 3

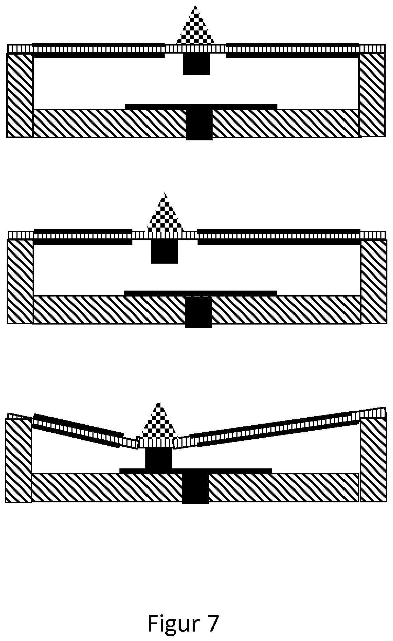

**Figur 7** zeigt in Seitenansicht ein Steuer- und Bedienelement mit Foliensensor mit zwei separaten Elektrodenfeldern und Fingerknauf oben in der Mitte sowie Kontaktelementen unten. Durch Herunterdrücken des Fingerknaufes wird zum Auslösen unten ein elektrischer Kontakt geschlossen. Die linke obere Figur zeigt das Steuer- und Bedienelement im nicht betätigten Zustand, die rechte obere Figur zeigt es im nach links verschobenen Zustand und die rechte untere Figur zeigt es im auslösenden Zustand.

### Ausführungsbeispiel 4

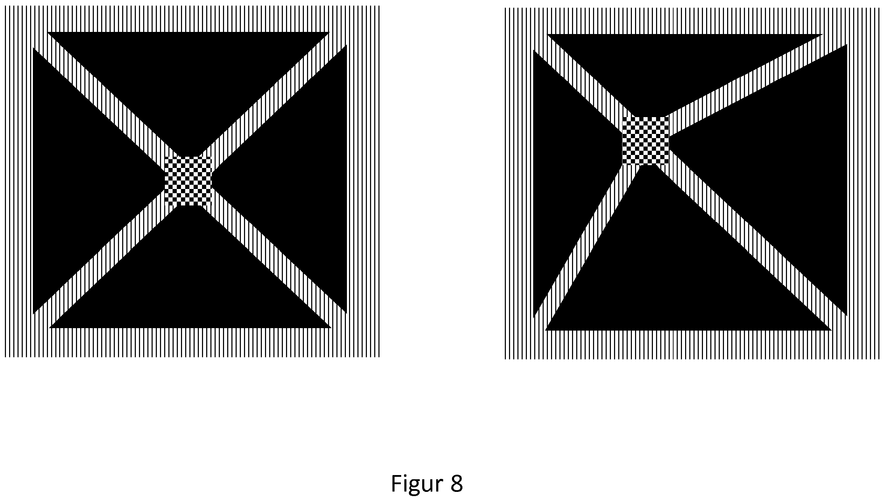

**Figur 8** zeigt in der Ansicht von oben ein Steuer- und Bedienelement mit Foliensensor mit vier separaten Rechteck-Elektrodenfeldern und Fingerknauf in der Mitte. Die linke Figur zeigt das Steuer- und Bedienelement im nicht betätigten Zustand, die rechte Figur zeigt es im nach links oben verschobenen Zustand.

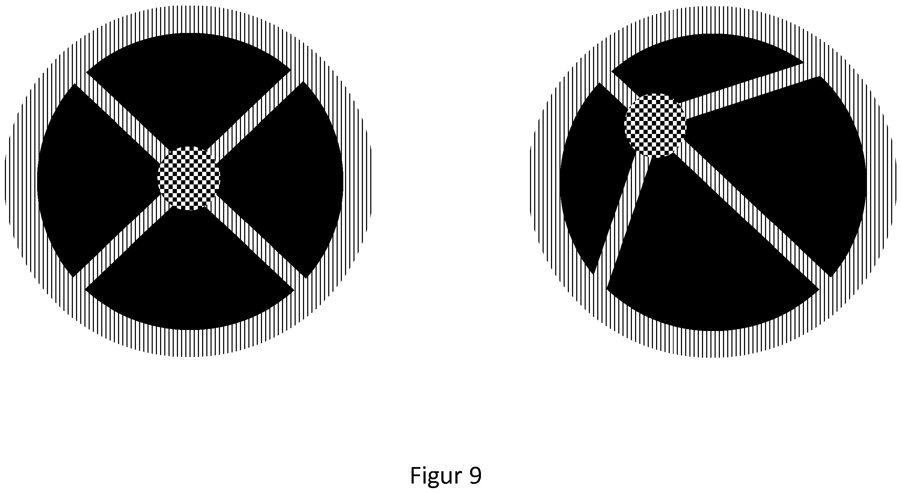

**Figur 9** zeigt in der Ansicht von oben ein Steuer- und Bedienelement mit Foliensensor mit vier separaten Kreissegment-Elektrodenfeldern und Fingerknauf in der Mitte. Die linke Figur zeigt das Steuer- und Bedienelement im nicht betätigten Zustand, die rechte Figur zeigt es im nach links oben verschobenen Zustand.

### Ausführungsbeispiel 5

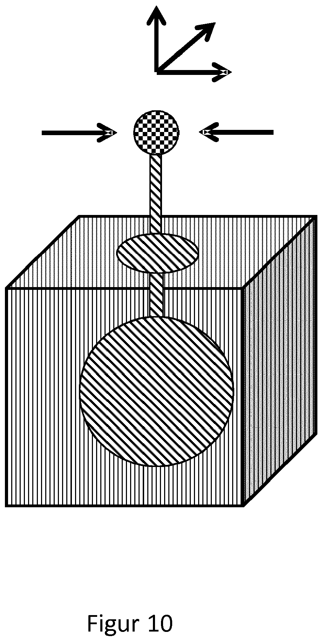

**Figur 10** zeigt ein Steuer- und Bedienelement mit 6 Drucksensoren auf den Flächen eines Würfels und mit einem Betätigungsstab mit Fingerknauf (Figur rechts). Die 5 Drucksensoren haben Noppenprofile wie in Figur 1 gezeigt und sind entsprechend zusammendrückbar. Durch Bewegen des Fingerknaufes wird eine Kugel oder ein anders geformter dreidimensionaler Körper im Inneren des Würfels verschoben und drückt abhängig von der Richtung der Bewegung auf unterschiedliche Drucksensoren, deren Kapazität separat gemessen wird. Damit wird eine dreidimensionale Verschiebung des Fingerknaufes erfasst. Das Auslösen kann durch Zusammendrücken des Fingerknaufes erfolgen, wenn dieser mit einem weiteren integrierten Drucksensor ausgestattet ist.

## Patentansprüche

1. Steuer- und Bedienelement, umfassend:
(a) mindestens einen Dielektrischen Elastomersensor, bei dem mindestens zwei Elektrodenschichten, zwischen denen eine Kapazität gemessen werden kann, durch ein zumindest teilweise elastomeres Dielektrikum voneinander getrennt sind,
wobei der Sensor eine voreingestellte Position besitzt und durch eine Verformung elastomerer Bestandteile eine oder mehrere Arbeitspositionen mit gegenüber der voreingestellten Position veränderter Kapazität einnehmen kann, die durch eine äußere Krafteinwirkung erreicht wird/werden, wobei die gemessene Kapazität dazu genutzt wird, um in dem Steuer- und Bedienelement eine Stellgröße zu steuern, und
(b) einen Auslösemechanismus, der ein Ereignis auslösen kann, das im Zusammenhang mit einer erreichten Arbeitsposition steht, wobei der Auslösevorgang beinhaltet, dass die zuvor mit Hilfe des Sensors erreichte(n) Arbeitsposition(en) und mit ihr/ihnen der dabei erhaltene Wert oder die erhaltenen Werte der Kapazität festgehalten und übernommen werden.

2. Steuer- und Bedienelement nach Anspruch 1, wobei
(a) der Dielektrische Elastomersensor eine mit Elektroden beschichtete Elastomerfolie oder eine zwischen zwei Elastomerkomponenten mit nach innen gerichteten profilierten Oberflächen angeordnete Elastomerfolie oder eine Elastomerfolie mit einer parallel angeordneten Elastomerkomponente mit auf die Folie gerichteter profilierter Oberfläche aufweist und die äußere Krafteinwirkung zumindest teilweise senkrecht zur Oberfläche der Elastomerfolie erfolgen kann, oder wobei
(b) der Dielektrische Elastomersensor mindestens eine Elastomerkomponente mit mindestens auf einer Seite profilierter Oberfläche oder einen Elastomerschaum aufweist und die äußere Krafteinwirkung durch eine Formveränderung des Profils der genannten Oberfläche oder durch die Stauchung des Elastomerschaums erfolgen kann.

3. Steuer- und Bedienelement nach Anspruch 1 oder 2, wobei die Elektrodenschichten zumindest teilweise aus elastomeren Komponenten bestehen.

4. Steuer- und Bedienelement nach einem der voranstehenden Ansprüche, wobei der Auslösemechanismus
(a) einen Stromkreis umfasst, der in der voreingestellten Position des Sensors unterbrochen ist und in einer Auslöseposition des Steuer- und Bedienelements geschlossen ist, oder der in der voreingestellten Position des Sensors geschlossen ist und in einer Auslöseposition des Steuer- und Bedienelements unterbrochen ist,
(b) das Messen der Geschwindigkeit der Kapazitätsänderung zwischen den beiden Elektrodenschichten umfasst und ein Schwellwert dieser Geschwindigkeit voreingestellt ist, dessen Überschreitung das Ereignis auslöst, oder
(c) das Messen von mindestens zwei Kapazitätsänderungen umfasst und eine Kombination von mindestens zwei Kapazitätsänderungen voreingestellt ist, bei deren Realisierung das Ereignis ausgelöst wird, oder
(d) einen zusätzlichen Dielektrischen Elastomersensor umfasst, bei dem mindestens zwei Elektrodenschichten, zwischen denen eine Kapazität gemessen werden kann, durch ein zumindest teilweise elastomeres Dielektrikum voneinander getrennt sind, wobei eine Kapazitätsänderung dieses zusätzlichen Dielektrischen Elastomersensors das Ereignis auslöst.

5. Steuer- und Bedienelement nach einem der voranstehenden Ansprüche, worin der mindestens eine Dielektrische Elastomersensor ein sich flächig erstreckender Elastomersensor ist.

6. Steuer- und Bedienelement nach Anspruch 4, Variante (a), und 5,
worin der Dielektrische Elastomersensor an mindestens einem seitlichen Bereich eine elektrisch leitende Struktur aufweist und der unterbrochene Stromkreis seitlich beabstandet zu dieser elektrisch leitenden Struktur eine überbrückbare Struktur besitzt, deren Überbrückung den genannten Stromkreis schließt, worin eine erste Komponente der äußeren Krafteinwirkung senkrecht zur Flächenrichtung des Dielektrischen Elastomersensors eine Veränderung der Kapazität zwischen den Elektroden bewirkt und worin eine zweite Komponente der äußeren Krafteinwirkung in Flächenrichtung des Dielektrischen Elastomersensors Bestandteile dieses Dielektrischen Elastomersensors seitlich verschiebt, derart, dass die elektrisch leitende Struktur an mindestens einem der seitlichen Enden des Dielektrischen Elastomersensors die überbrückbare Struktur beidseitig kontaktieren, damit den unterbrochenen Stromkreis schließen und das genannte Ereignis auslösen kann, oder
worin der unterbrochene Stromkreis eine überbrückbare Struktur besitzt, die sich beabstandet zum Dielektrischen Elastomersensor befindet, worin eine erste Komponente der äußeren Krafteinwirkung in Flächenrichtung des Dielektrischen Elastomersensors eine Veränderung der Kapazität zwischen den Elektroden bewirkt und eine zweite Komponente der äußeren Krafteinwirkung senkrecht zum Dielektrischen Elastomersensor eine elektrisch leitende Struktur des Dielektrischen Elstomersensors in Richtung der überbrückbaren Struktur drückt, derart, dass die elektrisch leitende Struktur die überbrückbare Struktur beidseitig kontaktiert, damit den zuvor unterbrochenen Schaltkreis schließt und das genannte Ereignis auslöst.

7. Steuer- und Bedienelement nach einem der Ansprüche 1 bis 3, worin der Dielektrische Elastomersensor mindestens zwei flächig nebeneinander angeordnete Sensorfelder besitzt, deren Elektrodenflächen nicht miteinander in Kontakt stehen, wobei die beiden Sensorfelder mechanisch vorgespannt sind und infolge der Krafteinwirkung mindestens eines der Felder unter Erhöhung der Spannung mechanisch weiter gedehnt wird und bei mindestens einem der Felder die mechanische Spannung verringert wird, wodurch sich die Größe der Felder in Relation zueinander verändert, die Dicke der dielektrischen Fläche zwischen den mindestens zwei Elektroden in dem mechanisch gedehnten Feld verringert und die Dicke der dielektrischen Fläche zwischen den mindesten zwei Elektroden in dem Feld mit verringerter mechanischer Spannung erhöht wird, wodurch die Kapazität des mechanisch gedehnten Feldes erhöht und die des Feldes mit verringerter mechanischer Spannung verringert wird.

8. Steuer- und Bedienelement nach Anspruch 7, worin die mindestens zwei flächig nebeneinander angeordneten Sensorfelder des Dielektrischen Elastomersensors dadurch realisiert sind, dass die mindestens zwei elastomeren Elektrodenschichten in strukturierter Form auf der dielektrischen Elastomerschicht aufgebracht sind, derart, dass jede dieser Schichten mindestens zwei elektrisch voneinander unabhängige Bereiche in den genannten Feldern bildet.

9. Steuer- und Bedienelement nach Anspruch 4(b) in Kombination mit Anspruch 7 oder 8, worin die Dehnung/die Verringerung der Spannung eines jeden Sensorfeldes zeitabhängig erfasst wird, derart, dass bei Überschreiten des voreingestellten Schwellwerts der Geschwindigkeit das Ereignis ausgelöst wird.

10. Steuer- und Bedienelement nach einem der Ansprüche 7 bis 9 mit mindestens vier flächig nebeneinander angeordneten Sensorfeldern, die durch zwei einander schneidende, elektrisch isolierende Bereiche voneinander abgegrenzt sind, wobei die Relation der gemessenen Kapazitäten in Relation zum Schnittpunkt der elektrisch isolierenden Bereiche erfasst und als zweidimensionaler Flächenpunkt dargestellt werden kann, derart, dass die äußere Krafteinwirkung in Flächenrichtung des Dielektrischen Elastomersensors als zweidimensionaler Bewegungsvektor darstellbar ist.

11. Steuer- und Bedienelement nach einem der voranstehenden Ansprüche, umfassend weiterhin eine elektrisch isolierte Greifeinrichtung, die auf einer einer bedienenden Person zugewandten Oberfläche des Sensors befestigt ist.

12. Steuer- und Bedienelement, umfassend:
(a) mindestens zwei sich vorzugsweise flächig in zwei unterschiedliche Raumrichtungen erstreckende Dielektrische Elastomersensoren, wobei bei jedem dieser Dielektrischen Elastomerschichten mindestens zwei Elektrodenschichten, zwischen denen eine Kapazität gemessen werden kann, durch ein zumindest teilweise elastomeres Dielektrikum voneinander getrennt sind,
wobei jeder der Sensoren eine voreingestellte Position besitzt und durch eine Verformung elastomerer Bestandteile eine oder mehrere Arbeitspositionen mit gegenüber der voreingestellten Position veränderter Kapazität einnehmen kann, die durch eine äußere Krafteinwirkung erreicht wird/werden, wobei die gemessene Kapazität dazu genutzt wird, um in dem Steuer- und Bedienelement eine Stellgröße zu steuern,
(b) einen Auslösemechanismus, der ein Ereignis auslösen kann, das im Zusammenhang mit einer erreichten Arbeitsposition steht, wobei der Auslösevorgang beinhaltet, dass die zuvor mit Hilfe des Sensors erreichte(n) Arbeitsposition(en) und mit ihr/ihnen der dabei erhaltene Wert oder die erhaltenen Werte der Kapazität festgehalten und übernommen werden,
sowie
(c) einen dreidimensionalen Körper mit einer Greifeinrichtung,
wobei alle genannten Dielektrischen Elastomersensoren und der dreidimensionale Körper so im Raum zueinander angeordnet sind, dass der Körper zwischen den Dielektrischen Elastomersensoren liegt und, gesteuert durch die Greifeinrichtung, auf jeden von ihnen eine äußere Krafteinwirkung ausüben kann.

13. Steuer- und Bedienelement nach Anspruch 12, worin der Auslösemechanismus in der Greifeinrichtung angeordnet ist und einen zusätzlichen Dielektrischen Elastomersensor aufweist, bei dem mindestens zwei Elektrodenschichten, zwischen denen eine Kapazität gemessen werden kann, durch ein zumindest teilweise elastomeres Dielektrikum voneinander getrennt sind, wobei eine Kapazitätsänderung dieses zusätzlichen Dielektrischen Elastomersensors das Ereignis auslöst.

14. Steuer- und Bedienelement nach Anspruch 12 oder 13, worin sechs dielektrische Elastomersensoren die sechs Flächen eines Würfels oder Quaders einnehmen und die Greifeinrichtung durch eine Durchbrechung eines der Elastomersensoren hindurch aus dem Würfel oder Quader nach außen ragt.

15. Verwendung eines Steuer- und Bedienelements nach einem der voranstehenden Ansprüche zur Steuerung von technischen Funktionen in Fahrzeugen, von Maschinen und von medizinischen Geräten, zur Bedienung von elektronischen Geräten wie Computern, Tablets, Smartphones und Spielekonsolen, oder zur Steuerung von technischen Funktionen am Körper, insbesondere in Form eines Elements, das in ein flexibles oder nachgiebiges Material, insbesondere eine Textilie, ein Kleidungsstück, einen Sitz, ein Bett oder eine Schaumstoff-Verkleidung, integriert ist.

## Claims

1. A control and operating element, comprising:
(a) at least one dielectric elastomer sensor, wherein at least two electrode layers, between which a capacitance can be measured, are separated from one another by an at least partially elastomeric dielectric,
wherein the sensor has a preset position and can adopt, owing to a deformation of elastomeric components, one or more working positions having a different capacitance with respect to the preset position, which is/are reached by an application of an external force,
wherein the measured capacitance is used to control a setting value in the control and operating element, and
(b) a triggering mechanism, capable of triggering an event that is associated with a reached working position, wherein the triggering mechanism comprises recording and adopting the working position/working positions and the associated capacitance value/capacitance values previously obtained by means of the sensor.

2. The control and operating element according to claim 1, wherein
(a) the dielectric elastomer sensor comprises an elastomer film that is coated with electrodes, or an elastomer film that is arranged between two elastomer components having inwardly directed profiled surfaces, or an elastomer film having a parallelly arranged elastomer component comprising a profiled surface facing the film, and wherein the external application of force can at least partially be exerted perpendicularly to the surface of the elastomer film, or wherein
(b) the dielectric elastomer sensor comprises at least one elastomer component having a profiled surface on at least one side, or comprises an elastomer foam, and wherein the external application of force can be exerted by a change of the shape of the profile of said surface or by compression of the elastomer foam.

3. The control and operating element according to claim 1 or 2, wherein the electrode layers consist at least partially of elastomeric components.

4. The control and operating element according to one of the preceding claims, wherein the triggering mechanism
(a) comprises an electric circuit that is open in the preset position of the sensor and closed in a triggering position of the control and operating element, or which is closed in the preset position of the sensor and open in the triggering position of the control and operating element,
(b) comprises measuring the rate of capacitance change between the two electrode layers, wherein a threshold value for this rate is preset, and the event is triggered when said threshold value is exceeded, or
(c) comprises measuring at least two capacitance changes, wherein a combination of at least two capacitance changes is preset, wherein the event is triggered when said combination is realized, or
(d) comprises an additional dielectric elastomer sensor, in which at least two electrode layers between which a capacitance can be measured, are separated from one another by an at least partially elastomeric dielectric, wherein a capacitance change of this additional dielectric elastomer sensor triggers the event.

5. The control and operating element according to one of the preceding claims, wherein the at least one dielectric elastomer sensor is a two-dimensionally extending elastomer sensor.

6. The control and operating element according to claim 4, variation (a), and claim 5, wherein the dielectric elastomer sensor comprises an electrically conductive structure on at least one lateral region and the open electric circuit has, laterally displaced to said electrically conductive structure, a bridgeable structure which, when bridged, closes said electric circuit, wherein a first component of the externally applied force perpendicular to the surface direction of the dielectric elastomer sensor causes a change of the capacitance between the electrodes, and wherein a second component of the externally applied force in the surface direction of the dielectric elastomer sensor laterally displaces parts of this dielectric elastomer sensor in such a way that the electrically conductive structure on at least one of the lateral ends of the dielectric elastomer sensor can contact the bridgeable structure on both sides in order to thereby close the open circuit and thereby trigger said event, or
wherein the open circuit has a bridgeable structure that is spaced apart from the dielectric elastomer sensor, wherein a first component of the externally applied force in the surface direction of the dielectric elastomer sensor causes a change of the capacitance between the electrodes, and a second component of the externally applied force perpendicular to the dielectric elastomer sensor presses an electrically conductive structure of the dielectric elastomer sensor in the direction of the bridgeable structure in such a way that the electrically conductive structure contacts the bridgeable structure on both sides in order to thereby close the previously open circuit and trigger said event.

7. The control and operating element according to any one of claims 1-3, wherein the dielectric elastomer sensor comprises at least two sensor fields that are arranged adjacent to one another in a plane and the electrode surfaces of which are not in contact with one another, wherein the two sensor fields are mechanically pre-stretched and, in response to the application of force, at least one of said fields is stretched further mechanically while the tension is increased, and the mechanical stress in at least one of the fields is reduced, whereby the size of the fields changes with respect to one another, the thickness of the dielectric face between the at least two electrodes is reduced in the mechanically stretched field and the thickness of the dielectric face between the at least two electrodes is increased in the field with reduced mechanical stress, whereby the capacitance of the mechanically stretched field is increased and the capacitance of the field with reduced mechanical stress is decreased.

8. The control and operating element according to claim 7, wherein the at least two sensor fields of the dielectric elastomer sensor, which are arranged adjacent to one another in a plane, are realized in that the at least two elastomeric electrode layers are applied on the dielectric elastomer layer in structured form in such a way that each of these layers forms at least two electrically independent regions in said fields.

9. The control and operating element according to claim 4(b) in combination with claim 7 or 8, wherein the stretching/the reduction of the stress of each sensor field is measured as a function of time in such a way that the event is triggered when the preset threshold value for said rate is exceeded.

10. The control and operating element according to any one of claims 7 to 9 comprising at least four sensor fields, which are arranged adjacent to one another in a plane, which are separated from each another by two intersecting, electrically insulating regions, wherein the relation of the measured capacitances is detected with respect to the intersecting point of the electrically insulating regions and can be displayed in the form of a two-dimensional surface point in such a way that the application of an external force in the surface direction of the dielectric elastomer sensor can be displayed as a two-dimensional motion vector.

11. The control and operating element according to any one of the preceding claims, further comprising an electrically insulated gripping device which is attached on a surface of the sensor that faces an operating person.

12. A control and operating element, comprising:
(a) at least two dielectric elastomer sensors that preferably extend two-dimensionally in two different directions in space, wherein for each of these dielectric elastomer layers, at least two electrode layers between which a capacitance can be measured, are separated from one another by an at least partially elastomeric dielectric,
wherein each of the sensors has a preset position and can adopt, owing to a deformation of elastomeric components, one or more working positions having a different capacitance with respect to the preset position, which is/are reached by an application of an external force, wherein the measured capacitance is used to control a setting value in the control and operating element,
(b) a triggering mechanism, capable of triggering an event that is associated with a reached working position, wherein the triggering mechanism comprises recording and adopting the working position/working positions and the associated capacitance value/capacitance values previously obtained by means of the sensor,
and
(c) a three-dimensional body comprising a gripping device,
wherein all said dielectric elastomer sensors and the three-dimensional body are arranged relative to one another in space such that the body lies between the dielectric elastomer sensors and, controlled by the gripping device, can exert an external force on each of the dielectric elastomer sensors.

13. The control and operating element according to claim 12, wherein the triggering mechanism is arranged in the gripping device and comprises an additional dielectric elastomer sensor in which at least two electrode layers, between which a capacitance can be measured, are separated from one another by an at least partially elastomeric dielectric, and wherein a capacitance change of this additional dielectric elastomer sensor triggers the event.

14. The control and operating element according to claim 12 or 13, wherein six dielectric elastomer sensors form the six faces of a cube or cuboid and the gripping device protrudes out of the cube or cuboid through an opening in one of the elastomer sensors.

15. A use of a control and operating element according to any one of the preceding claims for controlling technical functions in vehicles, of machines and of medical apparatuses, for operating electronic devices such as computers, tablets, smartphones and game consoles, or for controlling technical functions on the body, particularly in the form of an element that is integrated into a flexible or pliable material, particularly a textile, an article of clothing, a seat, a bed or a foam paneling.

## Revendications

1. Élément de pilotage et de commande, comprenant :
(a) au moins un capteur en élastomère diélectrique, dans lequel au moins deux couches électrodes, entre lesquelles une capacité peut être mesurée, sont séparées les unes des autres par un diélectrique au moins partiellement élastomère,
dans lequel le capteur a une position préréglée et peut adopter, par une déformation de constituants élastomères, une ou plusieurs positions de travail avec variation de la capacité par rapport à la position préréglée, qui est ou sont atteintes sous l'action d'une force extérieure, dans lequel la capacité mesurée est utilisée pour commander une grandeur de réglage dans l'élément de pilotage et de commande, et
(b) un mécanisme de déclenchement qui peut déclencher un événement qui est en relation avec une position de travail atteinte, dans lequel le processus de déclenchement inclut que la ou les positions de travail atteintes préalablement à l'aide du capteur et, avec celle-ci ou celles-ci, la ou les valeurs de capacité ainsi obtenues soient fixées ou adoptées.

2. Élément de pilotage et de commande selon la revendication 1, dans lequel
(a) le capteur en élastomère diélectrique présente une feuille élastomère recouverte d'électrodes ou une feuille élastomère disposée entre deux composants élastomères avec des surfaces profilées orientées vers l'intérieur ou une feuille élastomère avec un composant élastomère disposé parallèlement avec une surface profilée orientée sur la feuille et l'action de la force extérieure peut être réalisée au moins en partie perpendiculairement à la surface de la feuille élastomère, ou dans lequel
(b) le capteur en élastomère diélectrique présente au moins un composant élastomère, avec une surface profilée au moins sur un côté, ou une mousse élastomère et l'action de la force extérieure peut être réalisée par une modification de forme du profil de ladite surface ou par le refoulement de la mousse élastomère.

3. Élément de pilotage et de commande selon la revendication 1 ou 2, dans lequel les couches électrodes sont au moins en partie composées de composants élastomères.

4. Élément de pilotage et de commande selon une des revendications précédentes, dans lequel le mécanisme de déclenchement
(a) comprend un circuit électrique qui est interrompu dans la position préréglée du capteur et est fermé dans une position de déclenchement de l'élément de pilotage et de commande, ou qui est fermé dans la position préréglée du capteur et est interrompu dans une position de déclenchement de l'élément de pilotage et de commande,
(b) comprend la mesure de la vitesse de changement de capacité entre les deux couches électrodes et une valeur de seuil de cette vitesse est préréglée, son dépassement déclenchant l'événement, ou
(c) comprend la mesure d'au moins deux changements de capacité et une combinaison d'au moins deux changements de capacité est préréglée, dont la réalisation déclenche l'événement, ou
(d) comprend un capteur supplémentaire en élastomère diélectrique, dans lequel au moins deux couches électrodes, entre lesquelles une capacité peut être mesurée, sont séparées les unes des autres par un diélectrique au moins partiellement élastomère, dans lequel un changement de capacité de ce capteur supplémentaire en élastomère diélectrique déclenche l'événement.

5. Élément de pilotage et de commande selon une des revendications précédentes, dans lequel l'au moins un capteur en élastomère diélectrique est un capteur en élastomère s'étendant à plat.

6. Élément de pilotage et de commande selon la revendication 4, variante (a), et 5,
dans lequel le capteur en élastomère diélectrique présente, sur au moins une zone latérale, une structure électriquement conductrice et le circuit électrique interrompu a, à une certaine distance latéralement de cette structure électriquement conductrice, une structure qui peut être pontée et dont le pontage ferme ledit circuit électrique,
dans lequel une première composante de l'action de la force extérieure conduit, perpendiculairement à la direction de la surface du capteur en élastomère diélectrique, à un changement de capacité entre les électrodes et où une seconde composante de l'action de la force extérieure déplace latéralement, dans la direction de la surface du capteur en élastomère diélectrique, des constituants de ce capteur en élastomère diélectrique, de telle sorte que la structure électriquement conductrice vient en contact au moins avec une des extrémités latérales du capteur en élastomère diélectrique des deux côtés avec la structure qui peut être pontée afin de pouvoir ainsi fermer le circuit électrique interrompu et déclencher ledit événement, ou
dans lequel le circuit électrique interrompu a une structure qui peut être pontée qui se trouve à distance du capteur en élastomère diélectrique, où une première composante de l'action de la force extérieure conduit, dans la direction de la surface du capteur en élastomère diélectrique, à un changement de capacité entre les électrodes et une seconde composante de l'action de la force extérieure pousse, perpendiculairement au capteur en élastomère diélectrique, une structure électriquement conductrice du capteur en élastomère diélectrique en direction de la structure qui peut être pontée, de telle sorte que la structure électriquement conductrice vient en contact des deux côtés avec la structure qui peut être pontée en fermant ainsi le circuit électrique préalablement interrompu et en déclenchant ledit événement.

7. Élément de pilotage et de commande selon une des revendications 1 à 3, dans lequel le capteur en élastomère diélectrique a au moins deux cellules de capteur disposées à plat les unes à côté des autres, dont les surfaces d'électrodes ne sont pas en contact les unes avec les autres, dans lequel les deux cellules de capteur sont précontraintes mécaniquement et, sous l'action de la force, au moins une des cellules est mécaniquement à nouveau étendue sous l'augmentation de la tension et dans au moins une des cellules la tension mécanique est diminuée, ce qui permet de modifier la grandeur des cellules les unes par rapport aux autres, de diminuer l'épaisseur de la surface diélectrique entre les au moins deux électrodes dans la cellule étendue mécaniquement et d'augmenter l'épaisseur de la surface diélectrique entre les au moins deux électrodes dans la cellule avec la tension mécaniquement diminuée, ce qui permet d'augmenter la capacité de la cellule étendue mécaniquement et de diminuer celle de la cellule avec la tension diminuée mécaniquement.

8. Élément de pilotage et de commande selon la revendication 7, dans lequel les au moins deux cellules de capteur du capteur en élastomère diélectrique disposées à plat les unes à côté des autres sont réalisées de telle sorte que les au moins deux couches électrodes élastomères sont appliquées sur la couche en élastomère diélectrique dans une forme structurée de telle sorte que chacune de ces couches forme dans lesdites cellules au moins deux zones électriquement indépendantes les unes des autres.

9. Élément de pilotage et de commande selon la revendication 4(b) en combinaison avec la revendication 7 ou 8, dans lequel l'extension ou la diminution de la tension de chaque cellule de capteur est enregistrée en fonction du temps de telle sorte que, en cas de dépassement de la valeur de seuil préréglée de la vitesse, l'événement est déclenché.

10. Élément de pilotage et de commande selon une des revendications 7 à 9 avec au moins quatre cellules de capteur disposées à plat les unes à côté des autres, qui sont délimitées les unes des autres par deux zones électriquement isolées et qui s'interconnectent, dans lequel le rapport des capacités mesurées par rapport au point d'intersection des zones électriquement isolées peut être enregistré et peut être représenté sous la forme d'un point de surface bidimensionnel, de telle sorte que l'action de la force extérieure en direction de la surface du capteur en élastomère diélectrique peut être représentée sous la forme d'un vecteur de mouvement bidimensionnel.

11. Élément de pilotage et de commande selon une des revendications précédentes, comprenant en outre un moyen de préhension électriquement isolé qui est fixé sur une surface du capteur qui se trouve en regard d'une personne de pilotage.

12. Élément de pilotage et de commande, comprenant :
(a) au moins deux capteurs en élastomère diélectrique s'étendant de préférence à plat dans deux directions spatiales différentes, dans lequel, dans chacune de ces couches en élastomère diélectrique, au moins deux couches électrodes, entre lesquelles une capacité peut être mesurée, sont séparées les unes des autres par un diélectrique au moins partiellement élastomère,
dans lequel chacun des capteurs a une position préréglée et peut adopter, par une déformation de constituants élastomères, une ou plusieurs positions de travail avec variation de la capacité par rapport à la position préréglée, qui est ou sont atteintes sous l'action d'une force extérieure, dans lequel la capacité mesurée est utilisée pour commander une grandeur de réglage dans l'élément de pilotage et de commande,
(b) un mécanisme de déclenchement qui peut déclencher un événement qui est en relation avec une position de travail atteinte, dans lequel le processus de déclenchement inclut que la ou les positions de travail atteintes préalablement à l'aide du capteur et, avec celle-ci ou celles-ci, la ou les valeurs de capacité ainsi obtenues sont fixées ou adoptées,
ainsi que
(c) un corps tridimensionnel avec un moyen de préhension,
dans lequel tous lesdits capteurs en élastomère diélectrique et le corps tridimensionnel sont disposés les uns par rapport aux autres dans l'espace de telle sorte que le corps se trouve entre les capteurs en élastomère diélectrique et, commandé par le moyen de préhension, peut exercer l'action d'une force extérieure sur chacun de ceux-ci.

13. Élément de pilotage et de commande selon la revendication 12, dans lequel le mécanisme de déclenchement est disposé dans le moyen de préhension et présente un capteur supplémentaire en élastomère diélectrique, dans lequel au moins deux couches électrodes, entre lesquelles une capacité peut être mesurée, sont séparées les unes des autres par un diélectrique au moins partiellement élastomère, dans lequel un changement de capacité de ce capteur supplémentaire en élastomère diélectriques déclenche l'événement.

14. Élément de pilotage et de commande selon la revendication 12 ou 13, dans lequel six capteurs en élastomère diélectrique adoptent les six faces d'un cube ou d'un parallélépipède rectangle et le moyen de préhension fait saillie vers l'extérieur du cube ou du parallélépipède rectangle par un orifice traversant d'un des capteurs en élastomère.

15. Utilisation d'un élément de pilotage et de commandes selon une des revendications précédentes pour commander des fonctions techniques dans des véhicules, des machines et des appareils médicaux ainsi que pour le pilotage d'appareils électroniques tels que des ordinateurs, des tablettes, des téléphones intelligents et des consoles de jeux ou pour la commande de fonctions techniques au niveau du corps, en particulier sous la forme d'un élément qui est intégré dans un matériau flexible ou souple, en particulier un textile, un vêtement, un siège, un lit ou un revêtement en mousse.
